# EUROPÄISCHE PATENTSCHRIFT

(11) **EP 2 618 440 B1**
(45) Veröffentlichungstag und Bekanntmachung des Hinweises auf die Patenterteilung: **06.12.2017**
(21) Anmeldenummer: 12008366.2
(22) Anmeldetag: 15.12.2012
(51) Int. Cl.: H02H 7/18, G01R 31/36, H01M 10/44

(54) **"Schutzschaltung für einen Akkupack"**
Protective circuit for a battery pack
Circuit protecteur pour une batterie

(30) Priorität: 22.12.2011 DE 102011121937
(43) Veröffentlichungstag der Anmeldung: 24.07.2013
(73) Patentinhaber: Andreas Stihl AG & Co. KG, 71336 Waiblingen (DE)
(72) Erfinder: Liebhard, Gernot, D-71332 Waiblingen (DE); Gaul, Henrik, D-73614 Schorndorf (DE)
(74) Vertreter: Wasmuth, Rolf

(56) Entgegenhaltungen:
- WO-A2-03/069717
- WO-A2-2004/057723
- US-A1- 2010 123 434
- US-A1- 2011 003 182

## Beschreibung

Die Erfindung betrifft eine Schutzschaltung für eine Anordnung aus einer Vielzahl von Einzelzellen in einem Akkupack, wobei eine vorgegebene Anzahl von Einzelzellen in einer Zellreihe hintereinander geschaltet sind.

Derartige Akkupackanordnungen aus z. B. chemisch auf Lithium basierenden Zellen werden bei handgetragenen Arbeitsgeräten verwendet und sollen bei hoher Leistung eine lange Betriebsdauer des über den Akkupack mit Energie versorgten Gerätes sicherstellen. Ein großer Zellverbund ist nur so gut wie seine schwächste Zelle; altert eine Einzelzelle schneller als andere, wird die die schwächere Zelle enthaltende Zellreihe insgesamt beeinträchtigt, insbesondere können innerhalb des Akkupacks Ausgleichsströme fließen, die die Leistungsfähigkeit des gesamten Akkupacks einschränken. Liegt eine defekte Zelle vor, können innerhalb des Akkupacks auch dann Ausgleichsströme fließen, wenn keine äußere Last am Akkupack anliegt. Die gesunden Einzelzellen haben dadurch eine höhere Selbstentladung.

Aus der US 2011/0003182 A1, das den Oberbegriff des Anspruchs 1 bildet, ist eine Schutzschaltung für einen Akkupack aus drei parallelen Zellreihen bekannt, bei denen jeweils alle Potenziale zwischen den Einzelzellen einer Reihe miteinander verglichen und ausgewertet werden. Dies erfordert, insbesondere bei einem Akkublock mit einer Vielzahl von Zellen einen hohen schaltungstechnischen Aufwand. Eine entsprechende Schaltung von Einzelzellen zeigt die WO 03/069717 A2, in der einzelne Akkumodule zueinander parallel liegend zu einem Akkupack zusammengeschaltet sind. Jedes einzelne Akkumodul weist eine Schutzschaltung auf, wobei diese mehreren Schutzschaltungen miteinander verschaltet sind. Die Schutzschaltung einerseits ist mit allen Punkten gleichen Potenzials verbunden; eine Ausgleichsschaltung andererseits ist ebenfalls mit allen Punkten gleichen Potenzials verbunden. Der zur Überwachung und Sicherung des Akkublocks notwendige Schaltungsaufwand ist sehr hoch.

Der Erfindung liegt die Aufgabe zugrunde, eine Schutzschaltung für eine Anordnung aus mehreren parallelen Zellreihen aus einer Vielzahl von Einzelzellen in einem Akkupack derart auszubilden, dass ohne aufwendige Überwachung der Ausfall einer Einzelzelle in der gesamten Zellanordnung rasch und sicher erkannt werden kann.

Die Aufgabe wird nach den Merkmalen des Anspruchs 1 gelöst.

Im Akkublock liegen mehr als zwei Zellreihen zueinander parallel, wobei alle an gleicher Stelle der parallelen Zellreihen liegenden Zellverbinder über Ausgleichsleitungen miteinander elektrisch verbunden sind. Zwischen den Einzelzellen der Reihe sind jeweils Zellverbinder vorgesehen. Die an einer Stelle einer Zellreihe zwischen den Einzelzellen liegenden Zellverbinder sind über eine Ausgleichsleitung mit dem an einer gleichen Stelle einer parallelen Zellreihe liegenden Zellverbinder elektrisch verbunden. Dabei sind alle an gleicher Stelle der parallelen Zellreihe liegenden Zellverbinder über Ausgleichsleitungen elektrisch miteinander verbunden. Das Potenzial des mit der Ausgleichsleitung verbundenen Zellverbinders an der einen Stelle der einen Zellreihe wird als erste Messgröße erfasst. Das Potenzial des mit der Ausgleichsleitung elektrisch verbundenen Zellverbinders an der gleichen Stelle der parallelen Zellreihe wird ebenfalls als Messgröße erfasst. Die erfassten Potenziale werden einer Auswerteeinheit zugeführt und zweckmäßig in dieser ausgewertet, wobei das Auswertungsergebnis eine Aussage über eine defekte Zelle an der Stelle der Zellreihe zulässt. Innerhalb einer derartigen Parallelschaltung aus mehreren Zellreihen, werden die Potenziale der Zellverbinder der letzten Zellreihe der Parallelschaltung und die Potenziale der Zellverbinder der ersten Zellreihe der Parallelschaltung erfasst und ausgewertet. Die Zellreihen sind jeweils die äußeren Zellreihen einer Parallelschaltung.

Dabei werden in einfacher Weise die erfassten Potenziale der an gleicher Stelle in den parallelen Zellreihen liegenden Zellverbinder unmittelbar miteinander verglichen.

Sind die Einzelzellen paralleler Zellreihen etwa gleich stark und in der gleichen Kondition, werden bei Last wie im Ruhezustand über die Ausgleichsleitung keine nennenswerten Ströme fließen. Daher wird das Potenzial des Zellverbinders an der Stelle "2" in der einen Reihe das gleiche sein wie das Potenzial des an gleicher Stelle "2" liegenden Zellverbinders der parallelen Zellreihe, die darüber hinaus über die Ausgleichsleitung miteinander verbunden sind. Altern die Zellen unterschiedlich stark und brechen z. B. unter Last stärker ein als andere Einzelzellen einer Zellreihe, wird über die Ausgleichsleitung ein Ausgleichsstrom fließen, um die schwächere Zelle zu stützen. Aufgrund des Ausgleichsstroms in der Ausgleichsleitung und der dadurch an ihrem ohmschen Widerstand abfallenden Spannung, werden sich die Potenziale der miteinander verbundenen Zellverbinder unterschiedlich verändern. Der Potenzialunterschied zwischen den beiden Zellverbindern der gleichen Stelle paralleler Zellreihen ist somit ein Maß für den Ausgleichsstrom und somit ein Indikator für eine defekte Einzelzelle.

Durch Auswertung der Potenziale der Zellverbinder der einen, äußeren rechten Zellreihe mit den entsprechenden Potenzialen der Zellverbinder der anderen, äußeren linken Zellreihe kann ein Signal generiert werden, das z. B. zum Abschalten des Akkupacks genutzt werden kann.

In der Praxis hat sich gezeigt, dass bei einem großen Zellverbund von zehn und mehr in einer Reihe hintereinander liegenden Einzelzellen die aufeinanderfolgende Abfrage der Potenziale aller Zellverbinder einen Zeitraum von etwa 10 bis 150 ms benötigt. Auch die Abfrage zweier zu vergleichender Potenziale rechts und links eines Zellverbinders liegt zwischen 1 und 25 ms. Im Zeitraum einer Abfrage der Potenziale der jeweiligen Zellverbinder kann sich die elektrische Belastung der Einzelzellen ändern; eine Änderung der elektrischen Belastung führt aber zu einer Änderung des Potenzials am Zellverbinder selbst, so dass die erfassten Potenziale nicht mehr ohne Weiteres miteinander verglichen werden können. Nach einer Weiterbildung der Erfindung ist daher vorgesehen, die erfassten Potenziale durch Multiplikation mit einem vorgegebenen Faktor zu wichten bzw. zu faktorisieren. Der Wichtungsfaktor wird in Abhängigkeit der elektrischen Belastung im Zeitpunkt der Messung bestimmt und das gemessene Potenzial mit diesem Faktor entsprechend gewichtet. Durch den im Zeitpunkt der Messung bestimmten Faktor können alle erfassten Potenziale unabhängig von der elektrischen Belastung im Zeitpunkt der Messung direkt miteinander verglichen und ausgewertet werden. Aufgrund von elektrischen Belastungen aufgetretene Potenzialänderungen an den Zellverbindern verfälschen die Auswertung nicht.

Neben einer Wichtung bzw. Faktorisierung der Potenziale in Abhängigkeit der aktuellen elektrischen Belastung kann der Faktor auch in Abhängigkeit des Zeitpunktes der Messung gewählt werden, in Abhängigkeit eines symmetrischen oder unsymmetrischen Aufbaus des Zellverbundes im Akkupack oder in Abhängigkeit eines symmetrischen oder unsymmetrischen Kabelbaums des Akkupacks.

In einfacher Weise werden die faktorisierten Potenziale der an gleicher Stelle in den parallelen Zellreihen liegenden Zellverbinder unmittelbar miteinander verglichen und vorteilhaft durch Subtraktion eine Differenzspannung abgeleitet, deren Größe unmittelbar zum Abschalten des Akkupacks herangezogen werden kann. Überschreitet die Differenzspannung einen Schwellwert, wird ein Signal zum Abschalten des Akkupacks ausgegeben.

Vorteilhaft ist in einem Gehäuse des Akkupacks eine Auswerteeinheit vorgesehen, der die Potenziale der mit Ausgleichsleitungen verbundenen Zellverbinder der einen Zellreihe und die erfassten Potenziale der entsprechenden Zellverbinder einer parallelen Zellreihe zugeführt sind. Die Auswerteeinheit kann als Mikroprozessor ausgestaltet sein und über einen entsprechenden Algorithmus die Auswertung der jeweils erfassten Potenziale vornehmen.

Die in einer Zellreihe vorgesehenen Einzelzellen können als Zellblöcke ausgebildet sein, wobei ein Zellblock aus zumindest einer Einzelzelle besteht und die Zellverbinder die elektrischen Anschlusspole des Zellblocks bilden. Ein Zellblock kann auch aus mehreren Einzelzellen bestehen, die z. B. in Parallelschaltung gemeinsame Zellverbinder als Anschlusspole aufweisen. Innerhalb eines Zellblocks können die Einzelzellen aber auch in einer Reihenschaltung oder in einer Kombination aus Parallel- und Reihenschaltung verschaltet sein.

Der Schalter zum Abschalten des Akkupacks liegt zweckmäßig im Gehäuse des Akkupacks, so dass nach einem Abschalten aufgrund einer defekten Einzelzelle eine Wiederinbetriebnahme des Akkupacks verhindert ist. Zum Abschalten des Akkupacks ist zweckmäßig ein elektronischer Schalter, insbesondere ein MOSFET vorgesehen.

Weitere Merkmale der Erfindung ergeben sich aus den weiteren Ansprüchen, der Beschreibung und der Zeichnung, in der ein nachfolgend im Einzelnen beschriebenes Ausführungsbeispiel der Erfindung dargestellt ist. Es zeigen:
- Fig. 1: in schematischer Darstellung ein elektrisches Ersatzschaltbild eines Akkupacks,
- Fig. 2: in schematischer Darstellung einen Zellblock des Akkupacks nach Fig. 1,
- Fig. 3: ein Diagramm zur Auswertung der erfassten Potenziale,
- Fig. 4: in schematischer Darstellung ein elektrisches Ersatzschaltbild eines Akkupacks in anderer Ausführung.

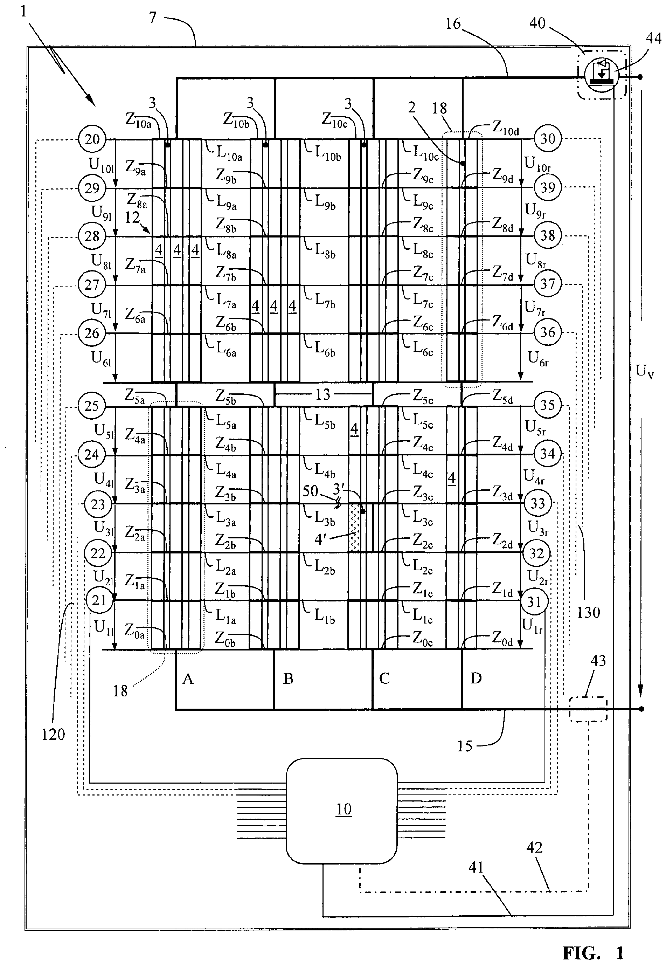

Im Ausführungsbeispiel nach Fig. 1 ist ein Akkupack 1 gezeigt, der aus einer Vielzahl von Zellblöcken 2, 3 aufgebaut ist. Im gezeigten Ausführungsbeispiel ist eine gleiche Anzahl von Zellblöcken 2 bzw. 3 zu jeweils einer Zellreihe A, B, C bzw. D hintereinander geschaltet. Die Zellreihen A, B, C und D liegen zueinander parallel und sind mit ihren Enden mit den Anschlusspolen 15 bzw. 16 des Akkupacks 1 verbunden. Zwischen den Anschlusspolen 15, 16 liegt die äußere Versorgungsspannung U_{V}.

Im Ausführungsbeispiel besteht eine Zellreihe A, B, C bzw. D aus je zehn Zellböcken 2 bzw. 3, die in einer Reihe hintereinander geschaltet sind. Dabei bilden je fünf Zellblöcke 2, 3 eine Baueinheit 18. Die Baueinheiten 18 einer Zellreihe A, B, C und D sind durch einen Leitungsabschnitt, insbesondere ein Kabel 13, miteinander elektrisch verbunden.

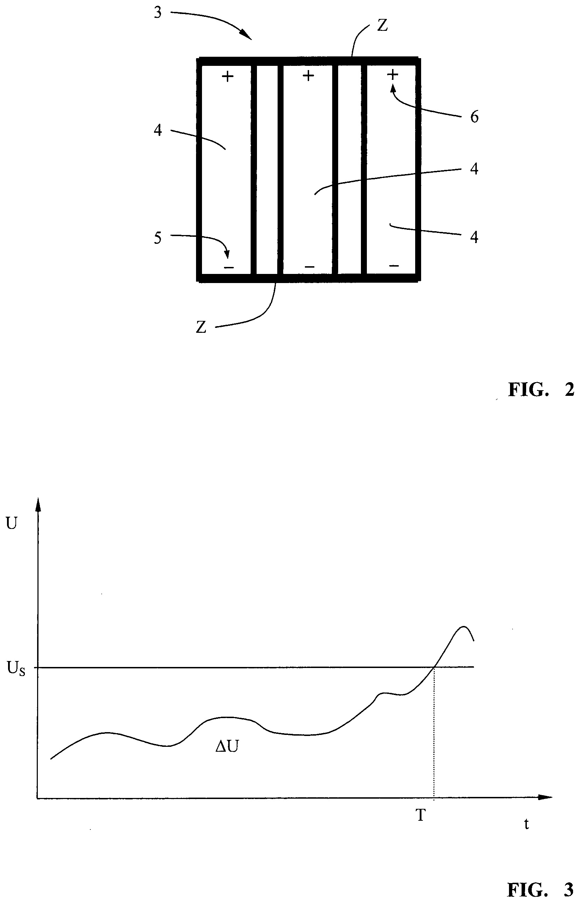

In Fig. 2 ist beispielhaft ein Zellblock 3 wiedergegeben. Im gezeigten Ausführungsbeispiel besteht der Zellblock 3 aus drei Einzelzellen 4, die elektrisch in Parallelschaltung geschaltet sind und deren Anschlüsse mit je einem Zellverbinder Z verbunden sind, der einen jeweiligen Anschlusspol 5, 6 des Zellblocks 3 bildet.

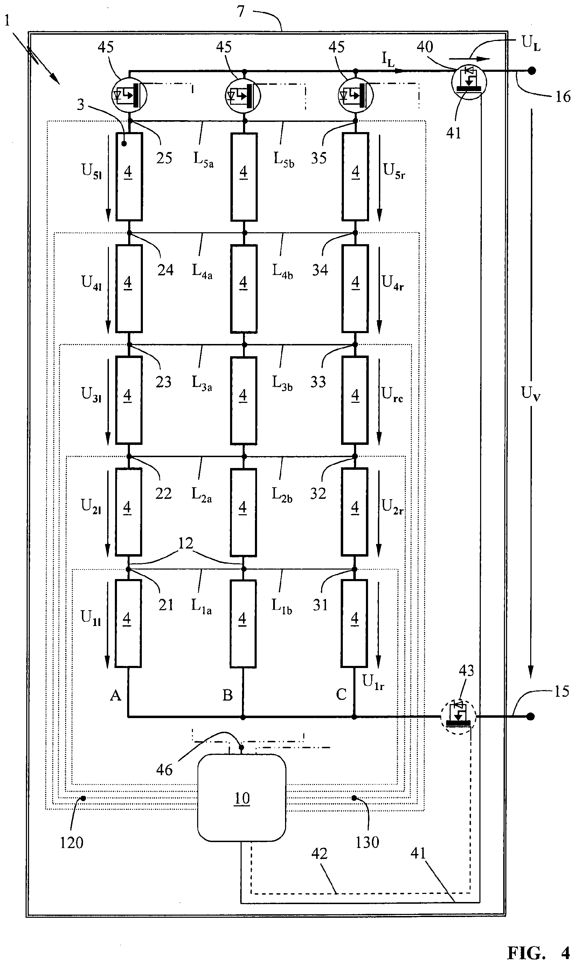

Wie Fig. 1 zeigt, sind die Zellblöcke 2 aus nur zwei in Parallelschaltung liegenden Zellen 4 gebildet; ein Zellblock kann auch aus nur einer Einzelzelle gebildet sein, wie in Fig. 4 schematisch wiedergegeben ist. Zweckmäßig besteht ein Zellblock 2, 3 aber aus mehreren Einzelzellen 4, die elektrisch in Parallelschaltung und/oder in Reihenschaltung verschaltet sind.

Der im Ausführungsbeispiel nach Fig. 1 aus vier parallelen Zellreihen A, B, C, D bestehende Akkupack 1 ist mit einer Vielzahl von Ausgleichsleitungen versehen, die allgemein mit Lₙₐ, L_{nb}, L_{nc} bezeichnet sind, wobei n eine natürliche Zahl ist, die im gezeigten Ausführungsbeispiel die Zahlen "0" bis "10" einnehmen kann. Die Ausgleichsleitungen Lₙₐ, L_{nb}, L_{nc} sind als elektrische Querverbindungen zwischen den Zellreihen A, B, C und D vorgesehen. Der Akkupack im dargestellten Ausführungsbeispiel hat zehn in Reihe hintereinander geschaltete Einzelzellen und stellt damit eine Versorgungsspannung von 36 Volt bereit. Wird eine höhere Versorgungsspannung gewünscht, z. B. 72 Volt, liegen zwanzig Einzelzellen in Reihe hintereinander; die Zahl n liegt dann im Bereich 0 ≤ n ≤ 20.

Im Ausführungsbeispiel liegen zwischen den Einzelzellen 4 bzw. den Zellblöcken 2 bzw. 3 einer Reihe A, B, C, D Zellverbinder, die sowohl die Einzelzellen 4 eines Zellblocks 2, 3 untereinander parallel verbinden und zugleich - als Leitungsabschnitt 12 entsprechend Fig. 4 - die elektrische Verbindung der Reihe der Zellblöcke 2, 3 hintereinander herstellen. Wie in Fig. 1 dargestellt, weist die Zellreihe A die Zellverbinder Z₀ₐ, Z₁ₐ, Z₂ₐ, Z₃ₐ, Z₄ₐ, Z₅ₐ, Z₆ₐ, Z₇ₐ, Z₈ₐ, Z₉ₐ, Z₁₀ₐ auf, die im Folgenden auch als Zellverbinder Zₙₐ (0 ≤ n ≤ 10) bezeichnet sind. Entsprechend weist die Zellreihe B zwischen den Zellblöcken 3 Zellverbinder Z_{nb}, also die Zellverbinder Z_{0b}, Z_{1b}, Z_{2b}, Z_{3b}, Z_{4b}, Z_{5b}, Z_{6b}, Z_{7b}, Z_{8b}, Z_{9b}, Z_{10b} auf, die allgemein mit Z_{nb} (0 ≤ n ≤ 10) bezeichnet sind. Die Zellverbinder zwischen den Zellblöcken 3 der Zellreihe C sind mit Z_{nc}, also Z_{0c}, Z_{1c}, Z_{2c}, Z_{3c}, Z_{4c}, Z_{5c}, Z_{6c}, Z_{7c}, Z_{8c}, Z_{9c}, Z_{10c} bezeichnet und allgemein mit Z_{nd} (0 ≤ n ≤ 10) benannt. Die Zellverbinder der Zellreihe D sind mit dem Bezugszeichen Z_{nd} (0 ≤ n ≤ 10), d. h., Z_{0d}, Z_{1d}, Z_{2d}, Z_{3d}, Z_{4d}, Z_{5d}, Z_{6d}, Z_{7d}, Z_{8d}, Z_{9d}, Z_{10d} bezeichnet. Bei einem Akkupack mit einer Versorgungsspannung von 72 Volt sind zwanzig Zellverbinder Zₙₐ (0 ≤ n ≤ 20), zwanzig Zellverbinder Z_{nb} (0 ≤ n ≤ 20), zwanzig Zellverbinder Z_{nc} (0 ≤ n ≤ 20) und zwanzig Zellverbinder Z_{nd} (0 ≤ n ≤ 20) vorgesehen. Entsprechend liegen zwischen den Zellverbindern Ausgleichsleitungen Lₙₐ, L_{nb}, L_{nc} mit 0 ≤ n ≤ 20.

Der Zellverbinder Z₁ₐ liegt in der Zellreihe A an der gleichen ersten Stelle wie der Zellverbinder Z_{1b} in der Zellreihe B, der Zellverbinder Z_{1c} in der Zellreihe C und der Zellverbinder Z_{1d} in der Zellreihe D. Entsprechend liegt somit jeder Zellverbinder Zₙₐ der Zellreihe A an gleicher n-ter Stelle wie der Zellverbinder Z_{nb} in der Zellreihe B, der Zellverbinder Z_{nc} in der Zellreihe C oder der Zellverbinder Z_{nd} der Zellreihe D.

Die Ausgleichsleitungen Lₙₐ, L_{nb} und L_{nc} verbinden jeweils die an gleicher n-ter Stelle in einer Zellreihe liegenden Zellverbinder Zₙₐ, Z_{nb}, Z_{nc} und Z_{nd} der Zellreihen A, B, C und D miteinander. So ist der an sechster Stelle der Zellreihe liegende Zellverbinder Z₆ₐ über die Ausgleichsleitung L₆ₐ mit dem an sechster Stelle in der Zellreihe B liegenden Zellverbinder Z_{6b} verbunden, der seinerseits über die Ausgleichsleitung L_{6b} mit dem an sechster Stelle der Zellreihe C liegenden Zellverbinder Z_{6c} der Zellreihe C verbunden ist. Der Zellverbinder Z_{6c} ist ferner über die Ausgleichsleitung L_{6c} mit dem an sechster Stelle der Zellreihe liegenden Zellverbinder Z_{6d} verbunden. Bezogen auf das in Fig. 1 dargestellte schematische Schaltbild sind die an einer n-Stelle in einer Zellreihe A, B, C, D liegenden Zellverbinder, also jeweils über Ausgleichsleitungen Lₙₐ, L_{nb}, L_{nc} mit den an gleicher n-ter Stelle liegenden Zellverbindern benachbarter Reihen verbunden. So steht der Zellverbinder Z₇ₑ mit den an gleicher Stelle liegenden Zellverbindern Z_{7b} und Z_{7d} der benachbarten Zellreihen B und D über die Ausgleichsleitungen L_{7b} und L_{7c} in Verbindung. Entsprechend steht z. B. der Zellverbinder Z_{2b} der Zellreihe B über die Ausgleichsleitungen L₂ₐ und L_{2b} mit den an gleicher Stelle der Zellreihen A und C liegenden benachbarten Zellverbindern Z₂ₐ und Z_{2c} in Verbindung. Allgemein ausgedrückt steht ein an einer n-ten Stelle einer Zellreihe A, B, C oder D zwischen den Zellblöcken 2 bzw. 3 liegender Zellverbinder Zₙₐ, Z_{nb}, Z_{nc}, Z_{nd} über eine Ausgleichsleitung Lₙₐ, L_{nb}, L_{nc} mit den an einer gleichen n-ten Stelle der parallelen Zellreihe A, B, C bzw. D liegenden Zellverbindern Zₙₐ, Z_{nb}, Z_{nc}, Z_{nd} elektrisch in Verbindung.

Die in Fig. 1 dargestellte Parallelschaltung eines Akkupacks 1 hat äußere Zellreihen A und D sowie innere Zellreihen B und C. Die Zellverbinder Z_{nb} und Z_{nc} der inneren Zellreihen B und C stehen jeweils mit den auf beiden Seiten einer Zellreihe liegenden Zellverbindern benachbarter Zellreihen elektrisch in Verbindung.

Die Zellverbinder Zₙₐ und Z_{nd} der äußeren Zellreihen A und D bilden Potenzialpunke 20 bis 29 bzw. 30 bis 39, wobei die zwischen den Potenzialpunkten liegende Spannung U₁ᵣ, U₂ᵣ, U₃ᵣ, U₄ᵣ, U₅ᵣ, U₆ᵣ, U₇ᵣ, U₈ᵣ, U₉ᵣ, U₁₀ᵣ (Uₙᵣ 1 ≤ n ≤ 10) bzw. U_{1L}, U_{2L}, U_{3L}, U_{4L}, U_{5L}, U_{6L}, U_{7L}, U_{8L}, U_{9L}, U_{10L} (U_{nL} 1 ≤ n ≤ 10) abgegriffen wird. So werden die Potenziale der Potenzialpunkte 20 bis 29 auf der linken Seite des Akkupacks, also die Potenzialpunkte 20 bis 29 der Zellreihe A, über Signalleitungen 120 der Auswerteeinheit 10 zugeführt. Entsprechend werden die Potenziale der Potenzialpunkte 30 bis 39 auf der rechten Seite der Parallelschaltung, also die Potenzialpunkte 30 bis 39 der äußeren Zellreihe D, über Signalleitungen 130 der Auswerteeinheit 10 zugeführt.

Innerhalb der Auswerteeinheit 10 werden die erfassten Spannungen Uₙᵣ, Uₙₗ bzw. die erfassten Potenziale ausgewertet und abhängig vom Ergebnis der Auswertung ein Signal generiert. Hierbei kann es zweckmäßig sein, das jeweils erfasste Potenzial Uₙᵣ, Uₙₗ vor der Auswertung zu faktorisieren, z. B. in Abhängigkeit des Zeitpunktes der Messung, der elektrischen Belastung des Akkupacks im Zeitpunkt der Messung, des konstruktiven Aufbaus des Akkupacks (symmetrisch, unsymmetrisch) oder der Ausführung der elektrischen Verkabelung (symmetrisch, unsymmetrisch) im Akkupack. Das als Ergebnis der Auswertung generierte Signal ist vorzugsweise als Steuersignal über eine Steuerleitung 41 einem Ausschalter 40 zugeführt, der im dargestellten Ausführungsbeispiel im Plus-Anschlusspol 16 des Akkupacks 1 vorgesehen ist. Ergänzend oder alternativ kann auch im Minus-Anschlusspol 15 ein Ausschalter 43 vorgesehen sein, der über die Steuerleitung 42 von der Auswerteeinheit 10 angesteuert ist. Die Ausschalter 40 und 43 sind im Gehäuse 7 des Akkupacks angeordnet und dienen dem Abschalten des gesamten Akkupacks 1, wenn die Auswerteeinheit 10 aufgrund von Abweichungen der erfassten Potenziale Uₙᵣ und Uₙₗ ein Signal generiert und über die Steuerleitung 41 bzw. 42 ausgibt.

Bevorzugt ist der Ausschalter 40 bzw. 43 als elektronischer Schalter 44 vorgesehen, insbesondere als MOSFET ausgebildet.

Im Betrieb des Akkupacks können über die Ausgleichsleitungen Lₙₐ, L_{nb}, L_{nc} Ausgleichsströme fließen, um ungleiche Ladungsmengen in den Einzelzellen 4 auszugleichen. Diese Ausgleichsleitungen Lₙₐ, L_{nb}, L_{nc} sind derart ausgelegt, dass sie die im Normalbetrieb auftretenden Ausgleichsströme sicher führen können.

Die Ausgleichsleitungen Lₙₐ, L_{nb} und L_{nc} sind vorteilhaft derart gestaltet, dass sie zugleich als Sicherungen zwischen den Zellreihen bzw. den Zellblöcken dienen. Liegen die Ausgleichsströme im normalen Betrieb innerhalb der zulässigen Grenzen, erfolgt eine derartige Ladungsverteilung zwischen den Zellblöcken, dass in diesen im Wesentlichen eine etwa gleiche Ladung gespeichert ist. Daher werden die Potenziale an den Potenzialpunkten 20 bis 29 jeweils den entsprechenden Potenzialen an den Potenzialpunkten 30 bis 39 entsprechen. Die Auswerteeinheit 10 wird somit auf der linken Seite der Parallelschaltung an den Potenzialpunkten 20 bis 29 Spannungen Uₙₗ erfassen, die etwa den Spannungen Uₙᵣ entsprechen, die sich zwischen den Potenzialpunkten 30 bis 39 auf der rechten Seite der Parallelschaltung ermitteln lassen. Ist z. B. die Spannung U₄ᵣ etwa so groß wie die Spannung U₄ₗ, kann davon ausgegangen werden, dass die in der Zellreihe A, B, C, D an vierter Stelle liegenden Zellblöcke Z₄ₐ, Z_{4b}, Z_{4c} und Z_{4d} ordnungsgemäß arbeiten.

Tritt hingegen in nur einer Einzelzelle 4' ein Defekt auf, z. B. im dritten Zellblock 3' der Zellreihe C, so werden über die Ausgleichsleitungen L_{2b} bzw. L_{2c} und L_{3b} bzw. L_{3c} erhöhte Ausgleichsströme fließen. Da die Ausgleichsleitungen vorteilhaft zugleich als Sicherungen ausgebildet sind, wird bei einem zu hohen Strom z. B. die Ausgleichsleitung L_{3b} schmelzen. So ist in Fig. 3 eine Unterbrechung 50 der Ausgleichsleitung L_{3b} angenommen. Aufgrund des nun fehlenden Ausgleichsstroms über die Ausgleichsleitung L_{3b} wird sich der Ladezustand des dritten Zellblocks 3' rascher ändern als die der übrigen Zellblöcke 2, 3. Dadurch aber ändert sich das Potenzial im Potenzialpunkt 33 in Bezug zum Potenzial des Potenzialpunktes 23 auf der linken Seite der Parallelschaltung. Die Auswerteeinheit 10 kann daher aufgrund der über die Signalleitungen 120, 130 zugeführten Potenziale der jeweiligen Potenzialpunkte 20 bis 29 bzw. 30 bis 39 erkennen, dass die zwischen den Potenzialpunkten 32 und 33 liegende Spannung U₃ᵣ von der auf der anderen Seite der Parallelschaltung zwischen den Potenzialpunkten 23 und 22 gemessenen Spannung U₃ₗ abweicht. Aufgrund der Abweichung wird ein Signal generiert, das als Steuersignal die Schalter 40 bzw. 43 im Akkupack betätigt. Der Akkupack 1 wird abgeschaltet. Eine weitere Schädigung der Einzelzellen ist vermieden.

In einfacher Weise werden die erfassten Potenziale Uₙᵣ und Uₙₗ der an gleicher n-ter Stelle liegenden Zellverbinder direkt miteinander verglichen und eine Differenzspannung ΔU gebildet, die permanent mit einem Schwellwert U_{S} verglichen wird (Fig. 3). In einem Akkupack liegt der Schwellwert U_{S} vorzugsweise bei etwa 10 bis 150 mV. Überschreitet die Differenzspannung ΔU den Schwellwert U_{S} zum Zeitpunkt T, wird ein Signal generiert, welches z. B. zum Abschalten des Akkupacks führt. Die in Fig. 3 dargestellten Schwankungen der Differenzspannung ΔU sind auf im Betrieb fließende Ausgleichsströme in den Ausgleichsleitungen zurückzuführen; erst wenn die Ausgleichsströme zu groß werden oder eine Ausgleichsleitung entsprechend ihrem Charakter als Sicherung unterbrochen wird, wächst die Differenzspannung ΔU über den Schwellwert U_{S} an und führt zu einem Abschalten des Akkupacks 1.

Im Ausführungsbeispiel basieren die Einzelzellen 4 chemisch auf Lithium; vorteilhaft sind die Einzelzellen 4 LiIon-Zellen, Li-Polymerzellen, LiFE-Zellen oder dgl. Zellen. Die Einzelzellen 4 können auch einen anderen chemischen Aufbau haben, z. B. NiCd, NiMh oder dgl..

Der in Fig. 4 gezeigte Akkupack 1 zeigt ein weiteres Ausführungsbeispiel einer Anordnung aus einer Vielzahl von Einzelzellen 4, wobei für gleiche Teile gleiche Bezugszeichen wie in Fig. 1 verwendet sind. Je Zellreihe A, B, C sind fünf Einzelzellen 4 vorgesehen, wobei in jeder Zellreihe A, B, C ein elektronischer Schalter 45 angeordnet sein kann, der über eine Steuerleitung 46 von der Auswerteeinheit 10 gesteuert ist. Die Einzelzellen 4 einer Reihe A, B, C sind über Leitungsabschnitte 12 verbunden; im Ausführungsbeispiel nach Fig. 1 sind die Leitungsabschnitte 12 durch die Zellverbinder Zₙₐ, Z_{nb}, Z_{nc}, Z_{nd} gebildet.

Entsprechend dem Ausführungsbeispiel in Fig. 1 werden die Zellspannungen der äußeren Reihen A und C erfasst, wozu die Potenzialpunkte 21 bis 25 bzw. 31 bis 35 über Signalleitungen 120, 130 mit der Auswerteeinheit 10 verbunden sind.

Ein Laststrom I_{L} führt an einem Innenwiderstand des Schalters 40 oder 43 der Anschlusspole 15, 16 zu einem messbaren Spannungsabfall U_{L}; dieser Spannungsabfall U_{L} kann erfasst und der Auswerteeinheit 10 als aktuelle Betriebsgröße zugeführt werden.

## Patentansprüche

1. Schutzschaltung für eine Anordnung aus einer Vielzahl von Einzelzellen (4) in einem Akkupack (1),
• wobei eine vorgegebene Anzahl von Einzelzellen (4) in einer Zellreihe (A, B, C, D) hintereinander geschaltet sind und mehr als zwei Zellreihen (A, B, C, D) zueinander parallel liegen,
• und zumindest ein an einer Stelle einer Zellreihe (A, B, C, D) zwischen den Einzelzellen (4) liegender Zellverbinder (Zₙₐ, Z_{nb}, Z_{nc}, Z_{nd}) über eine Ausgleichsleitung (Lₙₐ, L_{nb}, L_{nc}) mit dem an einer gleichen Stelle der parallelen Zellreihe (A, B, C, D) liegenden Zellverbinder (Zₙₐ, Z_{nb}, Z_{nc}, Z_{nd}) elektrisch verbunden ist,
• wobei alle an gleicher Stelle der parallelen Zellreihen (A, B, C, D) liegende Zellverbinder (Zₙₐ, Z_{nb}, Z_{nc}, Z_{nd}) über Ausgleichsleitungen (Lₙₐ, L_{nb}, L_{nc}) miteinander elektrisch verbunden sind,
• und das Potenzial (Uₙᵣ) des mit der Ausgleichsleitung (Lₙₐ, L_{nb}, L_{nc}) verbundenen Zellverbinders (Zₙₐ, Z_{nb}, Z_{nc}, Z_{nd}) der einen Stelle der einen Zellreihe (A) sowie das Potenzial (Uₙₗ) des mit der Ausgleichsleitung (dₙₐ, L_{nb}, L_{nc}) elektrisch verbundenen Zellverbinders (Zₙₐ, Z_{nb}, Z_{nc}, Z_{nd}) an der gleichen Stelle der parallelen Zellreihe (A, B, C, D) erfasst,
• und die erfassten Potenziale (Uₙᵣ, Uₙₗ) einer Auswerteeinheit (10) zugeführt werden, **dadurch gekennzeichnet,**
• **dass** innerhalb der Parallelschaltung aus mehr als zwei Zellreihen (A, B, C, D) die Potenziale (Uₙᵣ) der Zellverbinder (Z_{nd}) der äußeren, letzten Zellreihe (D) der Parallelschaltung und die Potenziale (Uₙₗ) der Zellverbinder (Zₙₐ) der äußeren, ersten Zellreihe (A) der Parallelschaltung erfasst und die erfassten Potenziale (Uₙᵣ, Uₙₗ) direkt miteinander verglichen und ausgewertet werden, und dass abhängig vom Ergebnis der Auswertung ein Signal generiert ist, das als Steuersignal zum Abschalten des Akkupacks (1) herangezogen wird.

2. Schutzschaltung nach Anspruch 1,
**dadurch gekennzeichnet, dass** die erfassten Potenziale (Uₙᵣ, Uₙₗ) durch Multiplikation mit einem vorgegebenen Faktor gewichtet sind.

3. Schutzschaltung nach Anspruch 1 oder 2,
**dadurch gekennzeichnet, dass** aus den erfassten Potenzialen (Uₙᵣ, Uₙₗ) der Zellverbinder (Zₙₐ, Z_{nb}, Z_{nc}, Z_{nd}) an der gleichen Stelle paralleler Zellreihen (A, B, C, D) eine Differenzspannung (ΔU) abgeleitet und mit einem vorgegebenen Schwellwert (Us) verglichen wird, wobei abhängig vom Überschreiten des Schwellwertes (Us) das Signal generiert ist.

4. Schutzschaltung nach einem der Ansprüche 1 bis 3,
**dadurch gekennzeichnet, dass** die Zellreihen (A, B, C, D) in einem Gehäuse (7) des Akkupacks (10) angeordnet sind und im Gehäuse (7) eine Auswerteeinheit (10) vorgesehen ist, der die Potenziale (Uₙᵣ, Uₙₗ) der mit Ausgleichsleitungen (Lₙₐ, L_{nb}, L_{nc}) verbundenen Zellverbinder (Zₙₐ, Z_{nb}, Z_{nc}, Z_{nd}) der einen Zellreihe (A, B, C, D) und die erfassten Potenziale (Uₙₗ) der Zellverbinder (Zₙₐ, Z_{nb}, Z_{nc}, Z_{nd}) einer parallelen Zellreihe (A, B, C, D) zugeführt sind.

5. Schutzschaltung nach einem der Ansprüche 1 bis 4,
**dadurch gekennzeichnet, dass** zumindest eine Einzelzelle (4) einen Zellblock (2, 3) bildet und die Zellverbinder (Z) die elektrischen Anschlusspole (5, 6) des Zellblocks (3) bilden.

6. Schutzschaltung nach Anspruch 5,
**dadurch gekennzeichnet, dass** ein Zellblock (2, 3) aus mehreren Einzelzellen (4) besteht, die elektrisch in Parallelschaltung und/oder Reihenschaltung verschaltet sind.

7. Schutzschaltung nach einem der Ansprüche 1 bis 6,
**dadurch gekennzeichnet, dass** das Signal aus den gemessenen Potenzialen (Uₙᵣ, Uₙₗ) generiert wird.

8. Schutzschaltung nach Anspruch 7,
**dadurch gekennzeichnet, dass** ein Schalter (40, 43) zum Abschalten des Akkupacks (1) in einem Gehäuse (7) des Akkupacks (1) angeordnet ist.

9. Schutzschaltung nach Anspruch 8,
**dadurch gekennzeichnet, dass** der Schalter (40) ein elektronischer Schalter (44) ist, insbesondere ein MOSFET ist.

10. Schutzschaltung nach einem der Ansprüche 1 bis 9,
**dadurch gekennzeichnet, dass** die Ausgleichsleitungen (Lₙₐ, L_{nb}, L_{nc}) als Sicherungen ausgelegt sind.

11. Schutzschaltung nach einem der Ansprüche 1 bis 10,
**dadurch gekennzeichnet, dass** die Einzelzellen (4) chemisch auf Lithium basierende Zellen sind, insbesondere Lithium-Ionen-Zellen sind.

## Claims

1. Protective circuit for an arrangement of a plurality of individual cells (4) in a battery pack (1),
• wherein a predetermined number of individual cells (4) are connected one behind the other in a cell row (A, B, C, D) and more than two cell rows (A, B, C, D) lie parallel to one another,
• and wherein at least one cell connector (Zₙₐ, Z_{nb}, Z_{nc}, Z_{nd}) located at a point of a cell row (A, B, C, D) between individual cells (4) is electrically connected to the cell connector (Zₙₐ, Z_{nb}, Z_{nc}, Z_{nd}) located at a same point of the parallel cell row (A, B, C, D) via a compensating line (Lₙₐ, L_{nb}, L_{nc}),
• wherein all cell connectors (Zₙₐ, Z_{nb}, Z_{nc}, Z_{nd}) located at the same point of the parallel cell rows (A, B, C, D) are electrically connected to one another via compensating lines (Lₙₐ, L_{nb}, L_{nc}),
• and wherein the potential (Uₙᵣ) of the cell connector (Zₙₐ, Z_{nb}, Z_{nc}, Z_{nd}) connected to the compensating line (Lₙₐ, L_{nb}, L_{nc}) of the one point of the one cell row (A) and the potential (Uₙₗ) of the cell connector (Zₙₐ, Z_{nb}, Z_{nc}, Z_{nd}) electrically connected to the compensating line (Lₙₐ, L_{nb}, L_{nc}) at the same point of the parallel cell row (A, B, C, D) are detected,
• and wherein the detected potentials (Uₙᵣ, Uₙₗ) are fed to an evaluation unit (10), **characterised in that**
• within the parallel circuit of more than two cell rows (A, B, C, D), the potentials (Uₙᵣ) of the cell connectors (Z_{nd}) of the outer, last cell row (D) of the parallel circuit and the potentials (Uₙₗ) of the cell connectors (Zₙₐ) of the outer, first cell row (A) of the parallel circuit are detected and the detected potentials (Uₙᵣ, Uₙₗ) are directly compared to one another and evaluated, and **in that**, depending on the result of the evaluation, a signal is generated which is used as a control signal for switching off the battery pack (1).

2. Protective circuit according to claim 1,
**characterised in that** the detected potentials (Uₙᵣ, Uₙₗ) are weighted with a predetermined factor by multiplication.

3. Protective circuit according to claim 1 or 2,
**characterised in that** a differential voltage (ΔU) is derived from the detected potentials (Uₙᵣ, Uₙₗ) of the cell connectors (Zₙₐ, Z_{nb}, Z_{nc}, Z_{nd}) at the same point of parallel cell rows (A, B, C, D) and compared to a predetermined threshold value (Uₛ), with the signal being generated if the threshold value (Uₛ) is exceeded.

4. Protective circuit according to any of claims 1 to 3,
**characterised in that** the cell rows (A, B, C, D) are arranged in a housing (7) of the battery pack (1) and an evaluation unit (10) is provided in the housing (7), to which evaluation unit (10) the potentials (Uₙᵣ, Uₙₗ) of the cell connectors (Zₙₐ, Z_{nb}, Z_{nc}, Z_{nd}) of the one cell row (A, B, C, D), which are connected to compensating lines (Lₙₐ, L_{nb}, L_{nc}), and the detected potentials (Uₙₗ) of the cell connectors (Zₙₐ, Z_{nb}, Z_{nc}, Z_{nd}) of a parallel cell row (A, B, C, D) are fed.

5. Protective circuit according to any of claims 1 to 4,
**characterised in that** at least one individual cell (4) forms a cell block (2, 3) and the cell connectors (Z) form the electric connecting terminals (5, 6) of the cell block (3).

6. Protective circuit according to claim 5,
**characterised in that** a cell block (2, 3) consists of a plurality of individual cells (4), which are electrically connected in parallel and/or in series.

7. Protective circuit according to any of claims 1 to 6,
**characterised in that** the signal is generated from the measured potentials (Uₙᵣ, Uₙₗ).

8. Protective circuit according to claim 7,
**characterised in that** a switch (40, 43) for switching off the battery pack (1) is located in a housing (7) of the battery pack (1).

9. Protective circuit according to claim 8,
**characterised in that** the switch (40) is an electronic switch, in particular a MOSFET.

10. Protective circuit according to any of claims 1 to 9,
**characterised in that** the compensating lines (Lₙₐ, L_{nb}, L_{nc}) are designed as fuses.

11. Protective circuit according to any of claims 1 to 10,
**characterised in that** the individual cells (4) are chemically based on lithium, being lithium ion cells in particular.

## Revendications

1. Circuit protecteur pour un dispositif composé d'un grand nombre d'éléments individuels (4) dans une batterie (1),
• un nombre prédéfini d'éléments individuels (4) étant montés les uns derrière les autres en une rangée d'éléments (A, B, C, D), et plus de deux rangées d'éléments (A, B, C, D) étant parallèles,
• et au moins un connecteur d'éléments (Zₙₐ, Z_{nb}, Z_{nc}, Z_{nd}) situé à un endroit d'une rangée d'éléments (A, B, C, D), entre les éléments individuels (4) est relié électriquement par l'intermédiaire d'une ligne d'équilibrage (Lₙₐ, L_{nb}, L_{nc}) au connecteur d'éléments (Zₙₐ, Z_{nb}, Z_{nc}, Z_{nd}) situé à un même endroit de la rangée d'éléments (A, B, C, D) parallèle,
• tous les connecteurs d'éléments (Zₙₐ, Z_{nb}, Z_{nc}, Z_{nd}) situés au même endroit des rangées d'éléments (A, B, C, D) parallèles étant reliés électriquement par l'intermédiaire de lignes d'équilibrage (Lₙₐ, L_{nb}, L_{nc}),
• et le potentiel (Uₙₗ) du connecteur d'éléments (Zₙₐ, Z_{nb}, Z_{nc}, Z_{nd}) relié à la ligne d'équilibrage (Lₙₐ, L_{nb}, L_{nc}) d'un endroit d'une rangée d'éléments (A) et le potentiel (Uₙₗ) du connecteur d'éléments (Zₙₐ, Z_{nb}, Z_{nc}, Z_{nd}) relié électriquement à la ligne d'équilibrage (Lₙₐ, L_{nb}, L_{nc}) du même endroit de la rangée d'éléments (A, B, C, D) parallèle étant relevés,
• et les potentiels (Uₙᵣ, Uₙₗ) relevés étant transmis à une unité d'évaluation (10), **caractérisé**
• **en ce qu'**à l'intérieur du montage parallèle composé de plus de deux rangées d'éléments (A, B, C, D), les potentiels (Uₙₗ) des connecteurs d'éléments (Z_{nd}) de la dernière rangée d'éléments, extérieure, (D) du montage parallèle, et les potentiels (Uₙₗ) des connecteurs d'éléments (Zₙₐ) de la première rangée d'éléments, extérieure, (A) du montage parallèle sont relevés, et les potentiels (Uₙᵣ, Uₙₗ) relevés sont directement comparés entre eux et évalués, et en ce qu'en fonction du résultat de l'évaluation est généré un signal de commande qui est utilisé pour arrêter toute la batterie (1).

2. Circuit protecteur selon la revendication 1,
**caractérisé en ce que** les potentiels (Uₙᵣ, Uₙₗ) relevés sont pondérés grâce à une multiplication par un facteur prédéfini.

3. Circuit protecteur selon la revendication 1 ou 2,
**caractérisé en ce qu'**une tension différentielle (ΔU) est dérivée des potentiels (Uₙᵣ, Uₙₗ) relevés des connecteurs d'éléments (Zₙₐ, Z_{nb}, Z_{nc}, Z_{nd}) au même endroit de rangées d'éléments (A, B, C, D) parallèles, et est comparée à une valeur seuil prédéfinie (Us), le signal étant généré en fonction du dépassement de la valeur seuil (U_{S}).

4. Circuit protecteur selon l'une des revendications 1 à 3,
**caractérisé en ce que** les rangées d'éléments (A, B, C, D) sont disposées dans un boîtier (7) de la batterie (10), et dans le boîtier (7) est prévue une unité d'évaluation (10) à laquelle sont transmis les potentiels (Uₙᵣ, Uₙₗ) des connecteurs d'éléments (Zₙₐ, Z_{nb}, Z_{nc}, Z_{nd}) reliés aux lignes d'équilibrage (Lₙₐ, L_{nb}, L_{nc}) d'une rangée d'éléments (A, B, C, D), et les potentiels (Uₙₗ) relevés des connecteurs d'éléments (Zₙₐ, Z_{nb}, Z_{nc}, Z_{nd}) d'une rangée d'éléments (A, B, C, D) parallèle.

5. Circuit protecteur selon l'une des revendications 1 à 4,
**caractérisé en ce qu'**au moins un élément individuel (4) forme un bloc d'éléments (2, 3), et les connecteurs d'éléments (Z) forment les pôles de raccordement (5, 6) du bloc d'éléments (3).

6. Circuit protecteur selon la revendication 5,
**caractérisé en ce qu'**un bloc d'éléments (2, 3) se compose de plusieurs éléments individuels (4) qui sont reliés électriquement en un montage en parallèle et/ou un montage en série.

7. Circuit protecteur selon l'une des revendications 1 à 6,
**caractérisé en ce que** le signal est généré à partir des potentiels (Uₙᵣ, Uₙₗ) mesurés.

8. Circuit protecteur selon la revendication 7,
**caractérisé en ce qu'**un commutateur (40, 43) destiné à arrêter la batterie (1) est disposé dans un boîtier (7) de celle-ci.

9. Circuit protecteur selon la revendication 8,
**caractérisé en ce que** le commutateur (40) est un commutateur électronique (44), en particulier un MOSFET.

10. Circuit protecteur selon l'une des revendications 1 à 9,
**caractérisé en ce que** les lignes d'équilibrage (Lₙₐ, L_{nb}, L_{nc}) sont conçues comme des coupe-circuits.

11. Circuit protecteur selon l'une des revendications 1 à 10,
**caractérisé en ce que** les éléments individuels (4) sont des éléments chimiquement à base de lithium, en particulier des éléments lithium-ion.
